# EUROPEAN PATENT APPLICATION

(11) **EP 4 647 841 A1**
(43) Date of publication of application: **12.11.2025**
(21) Application number: 24174556.1
(22) Date of filing: 07.05.2024
(51) Int. Cl.: G03F 7/20, G03F 1/84, G03F 9/00

(54) **SUBSTRATE PATTERN SYSTEM WITH SENSOR HEADS EMITTING LASER BEAMS FOR STAGE POSITION MEASUREMENT**

(71) Applicant: Mycronic AB, 183 03 Täby (SE)
(72) Inventor: Walther, Jonas, 169 37 Solna (SE); Mattsson, Daniel, 197 36 Bro (SE)
(74) Representative: AWA Sweden AB

(57) **Abstract**

A substrate pattern system (100) is provided. The substrate pattern system comprises a stage (150), a tool head (120), and a positioning system (170). The stage is configured to support a substrate (160). The tool head comprises an objective lens (122) having a focal point at a substrate supported by the stage. The tool head and/or the stage is movable to provide relative motion between the tool head and the stage along a first axis (X) and a second axis (Y). The positioning system comprises a first mirror (174x) arranged along a first edge of the stage. The first mirror has a first mirror surface facing the stage. The positioning system first comprises a second mirror (174_{Y}) arranged along a second edge of the stage. The second edge is adjacent to the first edge. The second mirror has a second mirror surface facing the stage. The positioning system further comprises a laser source (171), a first sensor head (173x), a second sensor head (173_{Y}), a detector (177), and a processor (176). The first sensor head is attached to the tool head. The first sensor head is configured to receive a first laser beam from the laser source, emit the first laser beam as a first measurement laser beam (Mx) toward the first mirror, and receive a first reflected laser beam from the first mirror. The second sensor head is attached to the tool head. The second sensor head is configured to receive a second laser beam from the laser source, emit the second laser beam as a second measurement laser beam (M_{Y}) toward the second mirror, and receive a second reflected laser beam from the second mirror. The detector is arranged to detect the first reflected laser beam and the second reflected laser beam. The processor is configured to determine a first position (x) along the first axis and a second position (y) along the second axis of the objective lens relative to the stage based on the first reflected laser beam and the second reflected laser beam.

## Description

### Technical field

The present disclosure relates generally to the field of patterned substrates and systems therefor. Specifically, it relates to a substrate pattern system with improved positioning.

### Background

Patterns in a micrometer or nanometer scale may be generated on substrates during the manufacture of photomasks, or to generate patterns directly onto a final substrate, so-called direct writing. In the production of semiconductor devices, photomasks are used as masters for mass production.

In micro- or nanolithography, an optical writing beam is focused onto a substrate using projection optics, wherein a photo-sensitive resist provided on the substrate may be exposed to the beam. By exposing different regions of the substrate at different intensities, a pattern may be generated on the substrate. Such optical lithography writers are capable of creating highly detailed patterns, with features in micrometer or nanometer scale, and provide a precise control of the design of the pattern. It is therefore crucial that the position of the writing beam is precisely measured and controlled with high accuracy. An important measure of quality of such a pattern, is the correctness of positions, such as X/Y positions, of reference features of the pattern on the substrate. To determine and evaluate such positions, a substrate pattern measurement system may be used. In such a system, the substrate is illuminated and high-resolution images of the substrate including the reference features are captured, based on which determination of the positions of the features may be made. Correct positioning of the optical imaging components above the substrate is therefore also important to make reliable measurements. Furthermore, to verify that the pattern has been correctly generated, e.g., that it has been generated with the correct resolutions and with features of the correct size and shape, a substrate with a pattern may be inspected using a substrate pattern inspection system. Such a system scans the substrate, using e.g., a line scan sensor, to identify potential pattern errors or contamination of the substrate. To accurately position such errors or contamination, precise positioning of the optical scanning components is required.

Some present solutions use interferometers for determining the position of an optical tool head relative to the substrate. Depending on the type of system, the optical tool head comprises optical components for either focusing a writing beam onto the substrate, or for collecting light from a target position at the substrate and guiding the light to the imaging or scanning sensor. These conventional interferometer solutions split a laser beam into multiple paths, one for each axis of movement, and determine a difference in distance between a mirror arranged on the optical head and a mirror arranged on a table carrying the substrate. To guide the laser beams from the laser source to the correct mirrors, a large number of optical components are used. The optical components require very stable support structures. The measurement accuracy may be affected by several factors, such as the laser beams being exposed to environmental changes and thermal gradients, minor displacement of the optical components, relative positioning of the mirrors, etc. There is therefore a need to improve the positioning of the optical tool head above the substrate in substrate pattern systems.

### Summary

It is therefore an object of the present invention to overcome at least some of the above-mentioned drawbacks, and to provide an improved positioning system for substrate pattern systems.

This and other objects are achieved by means of a substrate pattern system as defined in the appended independent claims. Other embodiments are defined by the dependent claims.

According to the present disclosure, a substrate pattern system is provided. The substrate pattern system comprises a stage, a tool head, and a positioning system. The stage is configured to support a substrate. The tool head comprises an objective lens having a focal point at a substrate supported by the stage. The tool head and/or the stage is movable to provide relative motion between the tool head and the stage along a first axis and a second axis. The positioning system comprises a first mirror and a second mirror, a laser course, a first sensor head and a second sensor head, a detector, and a processor. The first mirror is arranged along a first edge of the stage. The first mirror has a first mirror surface facing the stage. The second mirror is arranged along a second edge of the stage. The second edge is adjacent to the first edge. The second mirror has a second mirror surface facing the stage. The first sensor head is attached to the tool head. The first sensor head is configured to receive a first laser beam from the laser source, emit the first laser beam as a first measurement laser beam toward the first mirror, and receive a first reflected laser beam from the first mirror. The second head is attached to the tool head. The second sensor head is configured to receive a second laser beam from the laser source, emit the second laser beam as a second measurement laser beam toward the second mirror, and receive a second reflected laser beam from the second mirror. The detector is arranged to detect the first reflected laser beam and the second reflected laser beam. The processor is configured to determine a first position along the first axis and a second position along the second axis of the objective lens relative to the stage based on the first reflected laser beam and the second reflected laser beam.

The substrate pattern system may be a system for writing, measuring, inspecting, or otherwise treating or evaluating a pattern on a substrate.

The substrate pattern system may for example be a microlithography system or a nanolithography system. A nanolithography system may be capable of writing, measuring, or inspecting nanoscale patterns on a substrate, such as patterns having features smaller than 100 nm.

Throughout the present disclosure, the term "laser beam" may be shortened to "beam". For example, a "measurement laser beam" may be referred to as a "measurement beam", or a "first laser beam" may be referred to as a "first beam".

The tool head may comprise optical components, such as lenses, mirrors, prisms, beam splitters, deflectors, modulators, etc., arranged and configured to focus an optical writing beam onto the substrate, or to collect and guide light from a target position on the substrate to an imaging, scanning or other recording sensor. The tool head comprises an objective lens having a focal point at the substrate.

The tool head and/or the stage is movable to provide relative motion between the tool head and the stage along a first axis and a second axis. For example, the tool head may be movable along the first axis, and the stage may be movable along the second axis. Alternatively, the tool head may be movable along the first axis and the second axis. In another example, the stage may be movable along the first axis and the second axis. In some embodiments, the tool head or the stage may be fixed. Specifically, the first axis and the second axis may be parallel with a surface of the substrate. The first axis may be perpendicular to the second axis.

The first sensor head may be configured to emit the first measurement beam along, or parallel with, the first axis. The second sensor head may be configured to emit the second measurement beam along, or parallel with, the second axis.

The processor may be configured to determine the first position, along the first axis, based on the first reflected laser beam. The processor may be configured to determine the second position, along the second axis, based on the second reflected laser beam.

By arranging the sensor heads at the tool head, and emitting the laser beams from the tool head toward the mirrors arranged along the first and second edges of the stage, the point of measurement, i.e. the point at which the measurement is made, may be closer to the actual point of interest, i.e. the point on the substrate at which the optical components of tool head are focused. The point of interest may for example be a point on the substrate which is exposed by a writing beam, or a point on the substrate from which light is collected by a measurement or inspecting system. By bringing the point of measurement closer to the point of interest, measurement accuracy may be improved. By bringing the point of measurement closer to the point of interest, the effect of an Abbe error caused by an angular displacement, or tilting, of the tool head mirror or the tool head itself may be reduced.

In a conventional positioning system, a measurement beam is reflected off of a mirror on the tool head, while a reference beam is reflected off of a mirror arranged along an edge of the stage. The mirror arranged along the edge of the stage (the stage mirror) has a reflective surface facing away from the stage, to reflect the reference beam. In the conventional system, the measurement beam passes above the stage mirror. Thus, the measurement point, defined by the measurement beam, is separated from the substrate by a distance defined by an extension, or height, of the stage mirror above the stage. By arranging the sensor heads at the tool head, the measurement beam may be emitted closer to the substrate, thereby bringing the point of measurement closer to the point of interest (on the substrate).

According to some embodiments, the first sensor head may be optically connected to the laser source via a first optical fiber. The first sensor head may be configured to receive the first laser beam via the first optical fiber. The second sensor head may be optically connected to the laser source via a second optical fiber. The second sensor head may be configured to receive the second laser beam via the second optical fiber.

By connecting the laser source to the sensor head using optical fibers, the "open" portions of the optical paths of the laser beams, i.e., the portions of the optical paths in which the laser beams travel through air, are reduced. When travelling through air, the laser beams may be subject to environmental changes, such as temperature changes. By leading the laser beams through an optical fiber, the optical path may be more resistant to disturbances.

Further, the long open optical paths of the traditional interferometer system, require a number of optical components to guide the laser beams. The optical components are often arranged on a separate rack mounted on the substrate pattern system. The positioning accuracy of substrate pattern systems provide that these optical components are often made of expensive materials with low coefficients of thermal expansion, to minimize temperature induced variations in the optical paths. In embodiments in which the sensor head are connected to the laser source via optical fibers, the optical paths of the laser beams may be significantly simplified and require fewer components. The separate rack for holding the optical components may be replaced with holders for the optical fiber, which are usually much smaller and less bulky.

The present embodiments may also facilitate access to the substrate pattern system. When approaching conventional substrate pattern systems, the operator must take care not to interfere with the optical path of the interferometer laser beams. By instead arranging the sensor heads at the tool head and connecting the tool heads to the laser source with optic fibers, the open paths may be limited to an area between the tool head and the mirrors arranged at the edges of the stage. Thus, an operator may move more freely in the area around the substrate pattern system.

According to some embodiments, the first sensor head may be configured to generate a first reference beam. The second sensor head may be configured to generate a second reference beam. The detector may be configured to detect the first reference beam and the second reference beam. The processor may be configured to determine the first position and the second position based further on the first reference beam and the second reference beam.

Position may be determined based on a comparison of the reference beams and the measurement beams. The first position along the first axis may be determined based on a comparison of the first measurement beam and the second measurement beam.

By generating the first and second reference beams at the first and second sensor heads, the spatial separation, or offset, between the measurement beam and the reference beam may be reduced or completely removed. Angular errors increase with distance. The magnification of an angular error over distance is known as an Abbe error. By bringing the reference beam and the measurement beam closer together, the Abbe error between the beams may be reduced.

Further, a spatial separation of the measurement beam and the reference beam may lead to the two beams being exposed to different environmental conditions, which may affect the beams differently. Thus, by bringing the reference beam and the measurement beam closer together, the accuracy of the resulting measurement may be improved.

According to some embodiments, the first sensor head may be configured to generate the first reference beam by internal reflection at an end of the first optical fiber. The second sensor head may be configured to generate the second reference beam by internal reflection at an end of the second optical fiber.

According to some embodiments, the substrate pattern system may further comprise a first beam splitter arranged to split the first laser beam into the first measurement beam directed toward the first mirror and a first reference beam directed toward the detector. The substrate pattern system may further comprise a second beam splitter arranged to split the second laser beam into the second measurement beam directed toward the second mirror and a second reference beam directed toward the detector.

According to some embodiments, the tool head may further comprise an objective lens holder arranged to support the objective lens. The first sensor head may be arranged at the objective lens holder. The second sensor head may be arranged at the objective lens holder.

According to some embodiments, the first sensor head may be arranged to emit the first measurement beam along a first measurement axis which intersects an optical axis of an optical path through the objective lens. The second sensor head may be arranged to emit the second measurement beam along a second sensor head which intersects the optical axis.

The optical axis of the objective lens may intersect the point of interest on the substrate, as it may reflect the position at which the tool of the tool head interacts with the substrate. For example, in the case of a substrate pattern writer, the optical axis may be an optical axis of the (laser) writing beam. Thus, the optical axis may intersect a point on the substrate exposed by the writing beam. Alternatively, the optical axis may define an axis along which light at the point of interest is collected by the objective lens.

By aligning the measurement beams with the optical axis through the objective lens, the positioning accuracy may be improved, as the point of measurement may be aligned with the point of interest (or interaction) on the substrate.

According to some embodiments, the laser source and the detector may form part of an interferometer.

According to some embodiments, the tool head may be movable along a third axis, perpendicular to the first and second axis.

The third axis may be perpendicular to a surface of the substrate. As the first and second sensor heads are attached to the tool head, the first and second sensor heads may move together with the tool head along the third axis.

Substrates may come in many sizes and thicknesses. The substrate pattern system may for example be configured to adjust a distance between the tool head and the substrate, or the stage, to position the focal plane of the objective lens at the substrate. As the sensor heads are arranged at the tool head, the measurement beams may be emitted at a same height above the substrate, no matter the thickness of the substrate. This may increase measurement consistency between different substrates.

The measurement accuracy may be further improved in relation to systems in which mirrors are arranged on or at the tool head. In such systems, if the tool head is movable to adjust a difference between the tool head and the substrate, the position at which the measurement beam impinges the mirror may change as the tool head moves. Any angular deviation of the mirror arranged on the tool head, or of the tool head itself, from a perfectly perpendicular arrangement in relation to the measurement beam, may in turn lead to a variation in measured distance if the position at which the beam impinges the mirror changes.

According to some embodiments, the laser source may comprise a laser source beam splitter arranged to split a laser beam generated by the laser source into the first laser beam and the second laser beam.

Alternatively, the laser source may comprise a first laser source, configured to generate the first laser beam, and a second laser source, configured to generate the second laser beam.

In the present disclosure, the term substrate pattern system is used as an umbrella term covering different systems for writing, generating, measuring, inspecting, or otherwise treating or evaluating patterns, such as micro- or nanolithography patterns, on a substrate.

According to some embodiments, the substrate pattern system may be a substrate pattern writer. The substrate pattern writer may be configured to write a pattern into a resist layer on the substrate. The objective lens may be configured to focus a writing laser beam onto the resist layer.

A substrate pattern writer may write a pattern onto a substrate by selectively exposing the substrate to the writing laser beam. The substrate may for example comprise a resist layer. The substrate pattern writer may write, or draw, a desired pattern onto the substrate by selectively exposing the resist layer to the laser beam, to selectively activate the resist layer at desired positions. The substrate pattern writer may for example form part of a photomask generation system, wherein the substrate is subsequently treated to become a photomask. The substrate pattern writer may be a microlithography pattern generator, or a nanolithography pattern generator, capable of writing, drawing, or generating features in micrometer or nanometer scale.

The substrate pattern writer may further comprise a writing laser beam source. The objective lens may form part of an optical train conveying the writing laser beam from its source to the substrate. The optical train may further comprise other optical components in the tool head and potentially outside the tool head. For example, the optical train may comprise a modulator, for modulating the writing laser beam. The substrate pattern writer may be configured to modulate the writing laser beam based on pattern data describing a pattern to be generated on the substrate.

The substrate pattern writer may be a nanolithography writer,

When writing patterns in micrometer or nanometer scale, positioning accuracy of the tool head above the substrate is essential to ensure that the correct pattern is produced at the correct place. By further improving positioning accuracy, the resulting pattern accuracy may be further improved.

According to some embodiments, the substrate pattern system may be a substrate pattern inspection system. The substrate pattern inspection system may comprise an imaging unit configured to scan at least a portion of the substrate through the objective lens.

In other words, the objective lens may be configured to collect light at the substrate. The objective lens may form (part of) an optical train conveying the collected light to the imaging unit. The optical train may further comprise other optical components in the tool head and potentially outside the tool head.

The inspected substrate may be a patterned substrate. The substrate may have been patterned using a micro-/nanolithography process. The patterned substrate may be a photo mask.

The substrate pattern inspection system may further comprise an illumination unit configured to illuminate at least the portion of the substrate. This illumination unit may be arranged on a same side of the substrate as the objective lens, such that the objective lens is configured to collect light reflected at the substrate. Alternatively, or additionally, the illumination unit may be arranged on an opposite side of the substrate compared with the objective lens, such that the objective lens is configured to collect light transmitted by the substrate.

The imaging unit, or camera, scans at least a portion of the substrate. The imaging unit may for example comprise a line scan camera, which may allow for scanning at higher speeds than a 2D camera. Alternatively, the imaging unit may comprise a 2D camera. Embodiments including a 2D camera may comprise a pulsed illumination unit. The pulsed illumination unit may be synchronized with the 2D camera, such that the illumination illuminates the substrate at the same time as, or simultaneously with, the 2D camera capturing a 2D image of the substrate.

The substrate pattern inspection system may further comprise a processing unit for processing and/or evaluating scans from the imaging unit. For example, the substrate pattern inspection system may be used to detect defects on the substrate, such as errors in the pattern or contaminations by e.g., dust or other particles. When inspecting patterns in micrometer or nanometer scale, positioning accuracy of the tool head above the substrate is essential to ensure that any detected defects are logged at the correct place. By further improving positioning accuracy, the resulting pattern accuracy may be further improved.

According to some embodiments, the substrate pattern system may be a substrate pattern measurement system. The substrate pattern measurement system may comprise an imaging unit configured to capture an image of a portion of the substrate through the objective lens.

In other words, the objective lens may be configured to collect light at the substrate. The objective lens may form (part of) an optical train conveying the collected light to the imaging unit. The optical train may further comprise other optical components in the tool head and potentially outside of the tool head.

The inspected substrate may be a patterned substrate. The substrate may have been patterned using a micro- or nanolithography process. The patterned substrate may be a photo mask.

The substrate pattern measurement system may further comprise an illumination unit configured to illuminate at least the portion of the substrate. This illumination unit may be arranged on a same side of the substrate as the objective lens, such that the objective lens is configured to collect light reflected at/by the substrate.

The imaging unit captures an image of at least a portion of the substrate. The substrate pattern measurement system may further comprise a processing unit for processing and/or evaluating images captures by the imaging unit. For example, the substrate pattern measurement system may be used to measure or evaluate features of the pattern of the substrate. For example, the quality and placement of the pattern may be evaluated using the substrate pattern measurement system. When measuring patterns in micrometer or nanometer scale, positioning accuracy of the tool head above the substrate is essential to ensure that the recorded images are logged at the correct place. By further improving positioning accuracy, the resulting pattern accuracy may be further improved.

According to some embodiments, the substrate may be a substrate for a photomask or a wafer.

For example, the substrate may be manufactured into a photomask or reticle, which may in turn be used as a master for mass production of, e.g., semiconductor devices, such as displays. Alternatively, the substrate may be a wafer, onto which a laser writer, or substrate pattern writer, may generate a pattern. The wafer may be manufactured into a semiconductor device. A process in which the laser writer generates a pattern directly onto a substrate which is to be manufactured into a final semiconductor product may be referred to a direct writing process.

According to some embodiments, the positioning system may further comprise a third mirror and a third sensor head. The third sensor head may be arranged to receive a third laser beam from the laser source, emit the third laser beam toward the third mirror and receive a third reflected laser beam from the third mirror. The third mirror may be arranged at a fixed distance from the third sensor head. The detector may be further configured to detect the third reflected laser beam. The processor may be configured correct at least one of the determined first position and second position of the objective lens based on the reflected third laser beam.

The third sensor head and the third mirror may provide a reference measurement for the first and second positions. Specifically, as the third sensor head and the third mirror are arranged at a fixed, known, distance from another, any variations in the measurement made may result from e.g., environmental changes, such as humidity or temperature changes. The first and second measurement beams and reflected beams may be subject to the same or similar variations as the third laser beam and the third reflected beam. As the distance between the third sensor head and the third mirror is known, the measurements made based on the third reflected laser beam may be used to estimate, correct, or adjust the measurements made based on the first and/or the second reflected beams. Such a reference setup or measurement may be referred to as an etalon.

The third mirror may be the same as one of the first or the second mirror. Alternatively, the third mirror may be a separate mirror.

According to some embodiments, the third sensor head may be optically connected to the laser source via a third optical fiber.

It is noted that other embodiments using all possible combinations of features recited in the above-described embodiments may be envisaged. Thus, the present disclosure also relates to all possible combinations of features mentioned herein.

### Brief description of drawings

Exemplifying embodiments will now be described in more detail, with reference to the following appended drawings:
Figure 1 is an illustration of a substrate pattern system with a positioning system of the prior art;
Figure 2 is an illustration of an angular deviation resulting in an Abbe error;
Figure 3 is an illustration of a substrate pattern system in accordance with some embodiments;
Figure 4 is an illustration of a tool head equipped with sensor heads in accordance with some embodiments;
Figure 5 is an illustration of a substrate pattern system in accordance with some embodiments;
Figure 6 is an illustration of a tool head equipped with sensor heads in accordance with some embodiments;
Figure 7 is an illustration of a substrate pattern writer in accordance with some embodiments;
Figure 8 is an illustration of a substrate pattern inspection system in accordance with some embodiments; and
Figure 9 is an illustration of a substrate pattern measurement system in accordance with some embodiments.

As illustrated in the figures, the sizes of the elements and regions may be exaggerated for illustrative purposes and, thus, are provided to illustrate the general structures of the embodiments. Like reference numerals refer to like elements throughout.

### Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

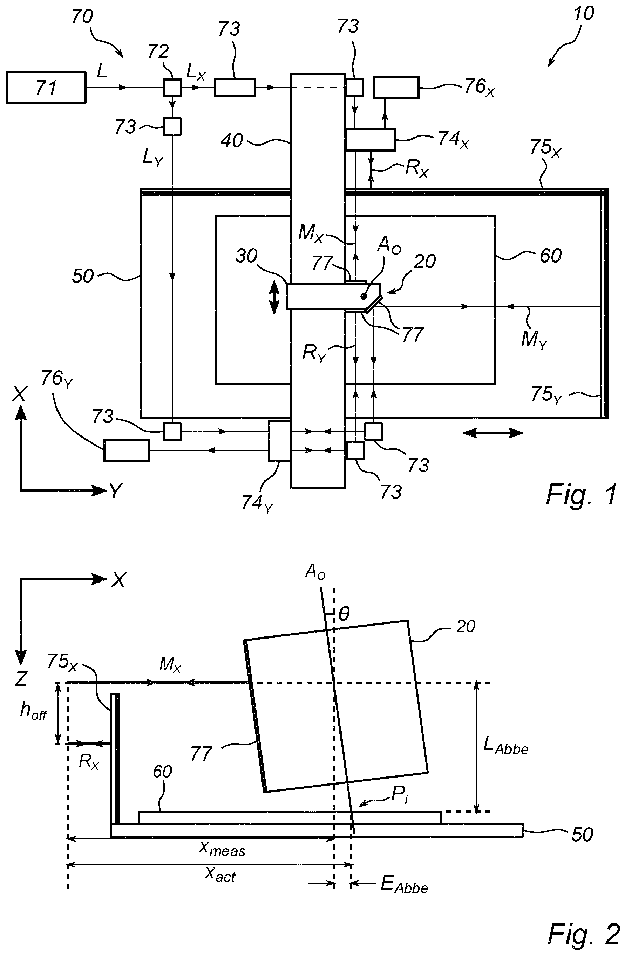

With reference to Figure 1, a substrate pattern system 10 with a prior art positioning system 70 will be described. Figure 1 illustrates a top-down view of a substrate pattern system 10.

The substrate pattern system 10 comprises a tool head 20 carried by a carriage 30. The carriage 30, or X-carriage, is movably arranged on a beam 40. The carriage 30 is movable along the beam 40 (or X-beam) in a first direction X, or along a first axis X. The beam 40 is arranged above a stage 50, on which a substrate 60 is arranged. The stage 50 is movable below the beam 40 in a second direction Y, or along a second axis Y. The tool head 20 comprises an objective lens having an optical axis Ao which is parallel with a third direction or axis Z. The objective lens may be configured to focus a laser writing beam onto the substrate 60 at a point of interest along the optical axis Ao. Alternatively, the objective lens may be configured to collect light at a point of interest on the substrate 60 along the optical axis Ao. The carriage 30, the beam 40, and the stage 50 are configured to allow the toolhead 20 to access all parts of the substrate 60 arranged on the stage 50. The position of the substrate 60 on the stage 50 is known. In order to determine a position of the tool head 20, or its objective lens, in relation to the substrate 60, the substrate pattern system 10 further comprises a positioning system 70.

The positioning system 70 comprises a laser beam generator 71 for generating a laser beam L. The laser beam L is split at a beam splitter 72 into to beams, one beam L_{X} for determining the position of the toolhead 20 in the X direction and one beam L_{Y} for determining the position of the toolhead 20 in the Y direction. Each beam is directed via a plurality of beam benders 73 to a dedicated interferometer 74_{X}, 74_{Y}. Each of the interferometers 74_{X}, 74_{Y} emit a measurement beam M_{X}, M_{Y} and a reference beam R_{X}, R_{Y}.

For measuring the X position, or position along the X direction/axis, the reference beam R_{X} is emitted towards, and reflected by, a first mirror 75_{X}. The first mirror 75_{X} is arranged along a first edge of the stage 50, with its reflective mirror surface facing away from the stage 50. The reflected reference beam R_{X} is detected at the interferometer 74_{X}. The measurement beam M_{X} is emitted above the mirror 75_{X} towards a mirror 77 on the tool head 20. The reflected measurement beam M_{X} is also detected at the interferometer 74_{X}.

For measuring the Y position, or position along the Y direction/axis, the measurement beam M_{Y} and the reference beam R_{Y} are emitted towards the tool head, via beam benders 73. The reference beam R_{Y} is reflected off a first mirror 77 on the toolhead, back towards its beam bender 73 and the interferometer 74_{Y}. The measurement beam M_{Y} is directed, by a mirror 77 arranged at 45 degrees on the toolhead 20, toward a second mirror 75_{Y}. The second mirror 75_{Y} is arranged along a second side of the stage 50 with its mirror surface facing toward the stage 50. The measurement beam M_{Y} is reflected back toward the 45-degree mirror 77, via the beam bender 73, to be detected by the interferometer 74_{Y}.

Based on the detected, reflected, measurement beams M_{X}, M_{Y} and reference beams R_{X}, R_{Y}, the interferometers 74_{X}, 74_{Y} respectively determine the X and Y positions of the tool head 20 above the substrate 60. The resulting X and Y positions are transmitted to a respective receiver 76_{X}, 76_{Y}.

Notably, in the prior art positioning system 70, the laser beams L, L_{X}, L_{Y} travel along long open beam paths, via a plurality of different optical components 72, 73, 77. Further, the measurement beams M_{X}, M_{Y} are spatially separated from their respective reference beams R_{X}, R_{Y}. This is further illustrated in Figure 2, which provides a lateral view of the tool head 20 arranged above the substrate 60, and illustrates the vertical separation h_{off}, or vertical offset, between the measurement beam M_{X} and the reference beam R_{X}.

The tool head 20 may be configured to move in the Z direction, relative to the stage 50 and the beam 40. For example, the tool head 20 may be configured to move in the Z direction to control a focus of an objective lens of the tool head 20, or to compensate for substrates 60 of different thicknesses. However, the optical components of the 72-74 of the positioning system 70 are stationary relative to the beam 40. Thus, the vertical separation h_{off} between the measurement beam M_{X} and the reference beam R_{X} must be large enough to take movement of the tool head in the Z direction into account. In other words, the vertical separation h_{off} must be large enough that the tool head 20, and specifically the mirror 77, does not move out of the beam path of the measurement beam M_{X} as the tool head 20 moves in the Z direction.

Further, as the optical components of the 72-74 of the positioning system 70 are stationary relative to the beam 40, while the tool head 20 may move in the Z direction, the position at which the measurement beam M_{X} impinges the mirror 77 may vary along the Z direction of the mirror, which may cause a variation in the resulting measurements, especially if the mirror 77 is not perfectly aligned with the Z axis.

With reference to Figure 2, the concept of an Abbe error will be explained.

In the present example, the measurement beam M_{X} is used to determine the position Pᵢ, at which the optical axis Ao intersects the substrate 60. In the illustrated example, the tool head 20 is not vertically arranged. Instead, the orientation of the tool head 20, and thus the optical axis Ao, deviates from a vertical line by an angle θ.

The positioning system 70 assumes that the tool head 20 is vertically oriented. Thus, as can be seen in Figure 2, there is a difference between the actual X position x_{act} of the point of interest Pᵢ and the measured position xₘₑₐₛ of the point of interest Pᵢ. The error, called an Abbe error E_{Abbe}, can be described as *E_{Abbe}* = *L_{Abbe}* sin *θ*. Thus, the larger the distance L_{Abbe} between the point of measurement and the point of interest Pᵢ, the larger the Abbe error E_{Abbe} will be. This may for example occur in the prior art system 70, where the measurement beam M_{X} must pass above the mirror 75_{X} to reach the tool head 20, resulting in the point of measurement being separated from the point of interest by at least approximately the height of the mirror 75_{X}.

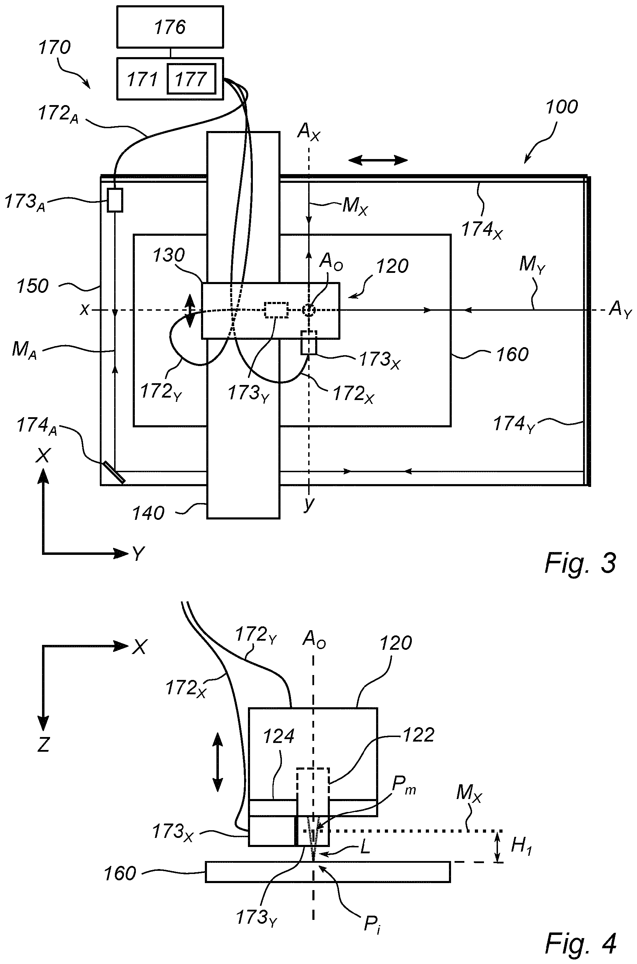

With reference to Figures 3 and 4, a substrate pattern system 100 in accordance with some embodiments will be described.

Figure 3 is a top-down view of a substrate pattern system 100. The substrate pattern system 100 may for example be of a large area type. A large area substrate pattern system 100 may be suitable for large substrates 160. For example, a large area substrate pattern system 100 may be suitable for substrates 160 having dimensions of up to 1.5×1.5 m, or more. Figure 4 is a close-up side view the tool head 120 of the substrate pattern system 100, equipped with sensor heads 173_{X}, 173_{Y} in accordance with some embodiments.

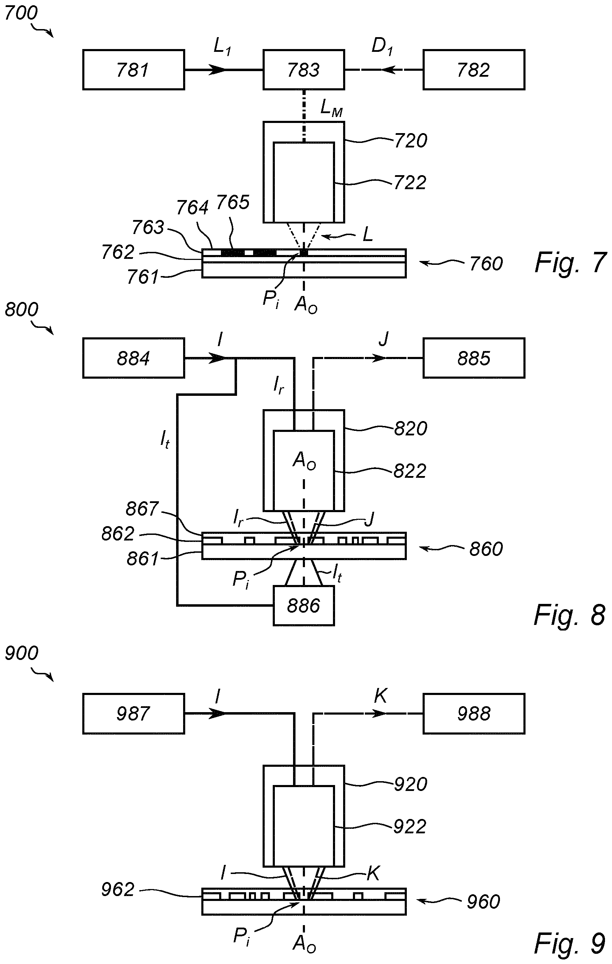

The substrate pattern system 100 comprises a tool head 120 carried by a carriage 130. The carriage 130, or X-carriage, is movably arranged on a beam 140. The carriage 130 is movable along the beam 140 (or X-beam) in a first direction X, along a first axis X. The beam 140 is arranged above a stage 150, on which a substrate 160 is arranged. The stage 150 is movable below the beam 140 in a second direction Y, along a second axis Y. The tool head 120 comprises an objective lens 122 having an optical axis Ao. In the illustrated embodiment, the optical axis Ao is parallel with a third axis Z. The objective lens 122 may be configured to focus a laser writing beam L onto the substrate 160 at a point of interest Pᵢ along the optical axis Ao. For example, the tool head 120 may be a writing head configured to focus a laser beam onto the substrate to write, draw or generate a pattern on the substrate. Alternatively, or additionally, the objective lens 122 may be configured to collect light J, K (as illustrated in Figures 8 and 9) at a point of interest Pᵢ on the substrate 160 along the optical axis Ao. For example, the tool head 120 may comprise components for collecting and transmitting light from a point of interest Pᵢ on the substrate to a light detector, such as an imaging device, to read, image, or inspect a surface of, or a pattern on, the substrate.

The carriage 130 is arranged to travel along the beam 140, such that the tool head 120 may access, e.g., read, write etc., the surface of the substrate along a width of the substrate 160 in the X direction. Further, the stage 150 is movable underneath the beam 140 to allow the tool head 120 to access the surface of the substrate along a length of the substrate 160 in the Y direction. Together, the carriage 130, the beam 140, and the stage 150 may be configured to allow the toolhead 120 to access all parts of the substrate 160 arranged on the stage 150.

A position of the substrate 160 on the stage 150 is known. In order to determine a position of the tool head 120, or the optical axis Ao of its objective lens 122, in relation to the substrate 160, the substrate pattern system 100 further comprises a positioning system 170.

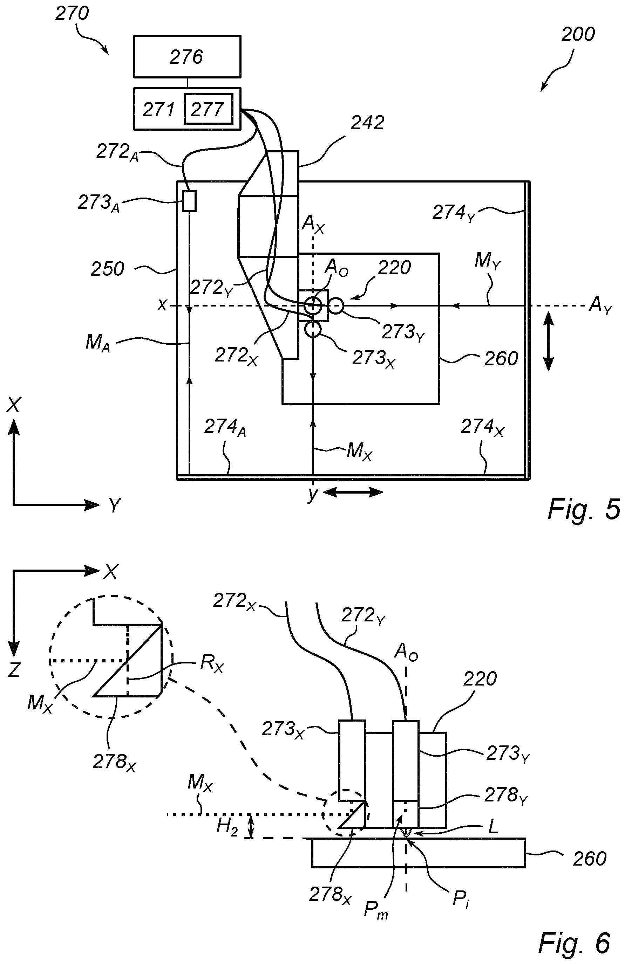

With reference to Figures 5 and 6, a substrate pattern system 200 in accordance with some embodiments will be described.

Figure 5 is a top-down view of a substrate pattern system 200. The substrate pattern system 200 may for example be of a small area type, or smaller area type, which may be suitable for smaller substrates 260. Figure 6 is a close-up side view the tool head 220 of the substrate pattern system 200, equipped with sensor heads 273_{X}, 273_{Y} in accordance with some embodiments.

The smaller area substrate pattern system 200 comprises a tool head 220 attached to a support structure 242. Differently from the substrate pattern system 100 described above with reference to Figures 3 and 4, the tool head 220 of the smaller area system 200 is fixedly attached to the support structure 242. Instead, the stage 250 is movable relative to the tool head 200, and the support structure 242, in the X and Y directions, i.e., along the first axis X and second axis Y.

Although not illustrated in Figured 5 and 6, the tool head 220 comprises an objective lens having an optical axis Ao, which may be equivalent to the objective lens 122 described in reference to Figure 4. In the illustrated embodiment, the optical axis Ao is parallel with a third axis Z.

The stage 250 is movable in the X and Y axes such that the tool head 220 may access, e.g., read, write etc., the surface of the substrate 260 along a width of the substrate 260 in the X direction and along a length of the substrate 260 in the Y direction. In other words, the stage 150 may be configured to move underneath the toolhead 220 on the support structure 242 to allow the toolhead 220 to access all parts of the substrate 260 arranged on the stage 250.

A position of the substrate 260 on the stage 250 is known. In order to determine a position of the tool head 220, or the optical axis Ao of its objective lens, in relation to the substrate 260, the substrate pattern system 200 further comprises a positioning system 270.

With reference to Figures 3-6, the positioning systems 170, 270 of the substrate pattern systems 100, 200 will be described in further detail.

The positioning systems 170, 270 each comprises a laser source 171, 271 configured to generate a laser beam. From the laser source 171, 271, a first laser beam is transmitted to a first sensor head 173_{X}, 273_{X} and a second laser beam is transmitted to a second sensor head 173_{Y}, 273_{Y}. The illustrated embodiments each include a single laser source 171, 271. The laser sources 171, 271 may each comprise a beam splitter for splitting a laser beam into the first and second laser beam. However, it will be appreciated that the positioning system may comprise a first laser source connected to the first sensor head and a second laser source connected to the second sensor head.

In each of the positioning systems 170, 270, the first and second sensor heads 173_{X}, 273_{X}, 173_{Y}, 273_{Y} are attached to the respective tool heads 120, 220. In the illustrated embodiments, the first and second laser beams are respectively transmitted from the laser source 171, 271 to the sensor heads 173_{X}, 173_{Y}, 273_{X}, 273_{Y} via first and second optical fibers 172_{X}, 172_{Y}, 272_{X}, 272_{Y}.

The first sensor head 173_{X}, 273_{X} is configured to receive the first laser beam from the laser source 171, 271 and emit a first measurement beam M_{X} toward a first mirror 174_{X}, 274_{X} arranged along a first edge of the stage 150, 250. A mirror surface of the mirror 174_{X}, 274_{X} is arranged facing the stage 150, 250 such that the measurement beam M_{X} is reflected back towards the tool head 120, 220 and to the sensor head 173_{X}, 273_{X} arranged thereon. In Figure 3, the first sensor head 173_{X} is arranged to emit the first measurement beam M_{X} in parallel with the first axis X, and in a positive direction of the first axis X. Thus, the first mirror 174_{X} is arranged along a first edge of the stage 150 which is illustrated at a top portion of Figure 3. In Figure 5, on the other hand, the first sensor head 273_{X} is arranged to emit the first measurement beam M_{X} in parallel with the first axis X, but in a negative direction of the first axis X. Thus, the first mirror 274_{X} is arranged along a first edge of the stage 250 which is illustrated at a bottom portion of Figure 5.

The sensor head 173_{X}, 273_{X} is configured to receive the first reflected laser beam and transmit the first reflected laser beam to a detector 177, 277. In the illustrated embodiments, a single detector 177, 277 is integrated with the laser source 171, 271. However, it will be appreciated that the positioning systems 170, 270 may comprise more than one detector 177, 277, such as one detector for the first measurement beam M_{X}, and one detector for a second measurement beam M_{Y}. Further, the detector(s) 177, 277 may be arranged elsewhere, such as in the tool head 120, 220, or in the sensor heads 173_{X}, 173_{Y}, 273_{X}, 273_{Y}.

A processor 176, 276 of the positioning system 170, 270 is configured to determine a first position x of the objective lens 122 relative to the stage 150, 250, and along the first axis, based on the first reflected laser beam.

Similarly, the second sensor head 173_{Y}, 273_{Y} is configured to receive the second laser beam from the laser source 171, 271 and emit a second measurement beam M_{Y} toward a second mirror 174_{Y}, 274_{Y} arranged along a second edge of the stage 150, 250. In both illustrated embodiments, the second sensor head 173_{Y}, 273_{Y} is arranged to emit the second measurement beam M_{Y} in parallel with the second axis Y, and in a positive direction of the second axis Y. Thus the first mirror 174_{Y}, 274_{Y} is arranged along a second edge of the stage 150, 250 which is illustrated at a right side portion of Figures 3 and 5. A mirror surface of the second mirror 174_{Y}, 274_{Y} is arranged facing the stage 150, 250 such that the measurement beam M_{Y} is reflected back towards the tool head 120, 220, and to the sensor head 173_{Y}, 273_{Y} arranged thereon. The sensor head 173_{Y}, 273_{Y} is configured to receive and transmit the second reflected laser beam to the detector 177, 277. The processor 176 of the positioning system 170 is configured to determine a second position y of the objective lens 122 relative to the stage 150 based on the second reflected laser beam.

The sensor heads 173_{X}, 173_{Y}, 273_{X}, 273_{Y} are arranged at the tool head 120, 220 to emit the first and second measurement beams M_{X}, M_{Y} respectively along a first measurement axis A_{X} and a second measurement axis A_{Y}. The first measurement axis A_{X} is parallel with the first axis, the X axis. The second measurement axis A_{Y} is parallel with the second axis, i.e., the Y axis. In Figure 4, the sensor heads 173_{X}, 173_{Y}, are arranged at an objective lens holder 124, to emit the M_{X}, M_{Y} at the objective lens holder 124. The objective lens holder 124 is a mechanical support structure for positioning the objective lens 122 in or at the tool head 120.

The sensor heads 173_{X}, 173_{Y}, 273_{X}, 273_{Y} may be arranged at an objective lens holder configured to support the objective lens 122. Thus, the sensor heads 173_{X}, 173_{Y}, 273_{X}, 273_{Y} may be arranged at the objective lens 122, and/or at a non-varying distance from the objective lens 122.

By arranging the sensor heads 173_{X}, 173_{Y}, 273_{X}, 273_{Y} at the tool head 120, 220, a point of measurement P_{M}, may be brought closer to the point of interest Pᵢ. The point of measurement P_{M} may be defined by an intersection of the first and second measurement axes A_{X}, A_{Y}. If the first and second measurement axes A_{X}, A_{Y} do not intersect, for example of the first sensor head 173_{X}, 273_{X} and the second sensor head 173_{Y}, 273_{Y} are arranged at different heights above the substrate, i.e., different positions along the Z axis, each sensor head 173_{X}, 173_{Y}, 273_{X}, 273_{Y} may have an individual point of measurement P_{M}. In the illustrated embodiments, however, the sensor heads 173_{X}, 173_{Y}, 273_{X}, 273_{Y} are arranged at least substantially at the same position along the Z axis. Thus, a single, or common, point of measurement P_{M} may be identified. By arranging the sensor heads 173_{X}, 173_{Y}, 273_{X}, 273_{Y}, at the tool head, the position measurements for determining the x and y positions of the objective lens 122 relative to the stage 150 may be made closer to the substrate 160. In Figures 4 and 6, the distance along the Z-axis between the measurement beams M_{X}, M_{Y} and the substrate 160, i.e., the height of the measurement beams M_{X}, M_{Y} above the substrate, are indicated respectively with H₁ and H₂. By arranging the sensor heads 173_{X}, 173_{Y}, 273_{X}, 273_{Y}, at the tool head 120, 220, this distance H1, H2, may be shorter than in prior art solutions, in which measurement laser beams are reflected on mirrors arranged on the tool head. By bringing the measurement point P_{M} closer to the point of interest Pᵢ, the effect of an Abbe error, as discussed above with respect to Figure 2, may be reduced.

In the illustrated embodiments, each of the first and second measurement axes A_{X}, A_{Y} intersect the optical axis Ao of the objective lens 122. In Figures 5 and 6, the measurement beams M_{X}, M_{Y} are emitted in a direction away from the optical axis Ao. However, as is illustrated with dashed lines, the measurement axes A_{X}, A_{Y}, along which the measurement beams M_{X}, M_{Y} are emitted, intersect the optical axis Ao. Thus, the measurement point P_{M} is aligned with the point of interest Pᵢ, along the optical axis Ao, and the distance between the measurement point P_{M} and the point of interest Pᵢ is equal to the height H1, H2.

In some embodiments, as is illustrated in Figure 4, the tool head 120 may be movable in a third direction, along the Z axis. For example, the tool head 120, may be movable along the Z axis to adjust a focus or a focus plane of the objective lens 122 relative to the substrate 160. The sensor heads 173_{X}, 173_{Y} may move together with the tool head 120, such that the relative position between the point of measurement P_{M} and the objective lens 122 remains constant. Thus, with the present systems 100, 200, a variation in measurements caused by movement of the tool head 120, 220, in the third (Z) direction may be reduced or removed. Thus, the systems 100, 200 according to the present disclosure may provide improved adaptability to substrates 160, 260 of different thicknesses.

The sensor heads 173_{X}, 173_{Y}, 273_{X}, 273_{Y} are configured to generate a reference beam as well as the measurement beam M_{X}, M_{Y}. The sensor heads 173_{X}, 173_{Y}, 273_{X}, 273_{Y} are further configured to transmit the reference beam together with the received reflected measurement beam to the detector 177, 277. The processor 176, 276 may determine the position x,y of the objective lens 122 relative to the stage 150, 250 based on a comparison between the detected reference beam and the detected reflected measurement beam. For example, the positioning system 170, 270 may comprise an interferometer system. At least some components of the positioning system 170, 270 may form part of an interferometer system.

In the system 100, illustrated in Figures 3 and 4, the sensor heads 173_{X}, 173_{Y} are horizontally arranged to emit the measurement beams M_{X}, M_{Y} in parallel with the substrate's 160 surface. The sensor heads 173_{X}, 173_{Y} may be configured to generate the reference beams by internal reflection at ends of the respective optical fibers 172_{X}, 172_{Y}, such as ends of the respective optical fibers 172_{X}, 172_{Y} located inside or at the sensor heads 173_{X}, 173_{Y}. Alternatively, the sensor heads 173_{X}, 173_{Y} may comprise respective beam splitters (not illustrated) arranged to generate the first and second reference beams.

In the system 200, illustrated in Figured 5 and 6, the sensor heads 273_{X}, 273y are arranged vertically, i.e., along the Z axis, on the tool head 220. The sensor heads 273_{X}, 273y further comprises a respective beam splitter 278_{X}, 278y. In Figure 6, the beam splitters 278_{X}, 278y are arranged outside of a main body of the sensor heads 273_{X}, 273y. The beam splitters 278_{X}, 278y are arranged to deflect the measurement beams M_{Y}, M_{X}, along the first and second measurement axes A_{X}, A_{Y}, and to generate respective reference beams RX directed back toward the main body of the sensor head 273_{X}, 273y for further transmission to the detector 277. The beam splitters 278_{X}, 278y are further arranged to guide the reflected reference beams back toward the main bodies of the respective sensor heads 273_{X}, 273y. While the sensor heads 273_{X}, 273y are arranged vertically in Figures 5 and 6, it will be appreciated that the sensor heads may instead be horizontally arranged, or arranged with another orientation at the tool head 20, together with beam splitters arranged to, e.g., direct the measurement beams M_{Y}, M_{X}, along the first and second measurement axes A_{X}, A_{Y}, as described above.

Laser beams travelling through open air, such as the measurement beams M_{X}, M_{Y}, may be subject to atmospheric changes. If, e.g., the surrounding temperature varies between measurements, the positioning accuracy may also vary. To better account for such variations, the positioning systems 170, 270 further comprise a standard or an etalon illustrated in Figures 3 and 5. Specifically, the positioning systems 170, 270 further comprise a third sensor head 173_{A}, 273_{A} connected to the laser source 171, 271. The third sensor head 173 _{A}, 273_{A} is configured to emit a third laser beam MA toward a third mirror 174_{A}, 274_{A}, and receive a reflected third measurement beam from the third mirror 174_{A}, 274_{A}. The third sensor head 173 _{A}, 273_{A} is further configured to transmit the reflected third measurement beam to the detector 177, 277. The third mirror 174_{A}, 274_{A} is arranged at a fixed distance from the third sensor head 173_{A}, 273_{A}. That is, the distance between the third sensor head 173_{A}, 273_{A}, and the third mirror 174_{A}, 274_{A}, does not vary during operation of the system 100, 200. Changes in distance measured using the third measurement beam may therefore be caused by atmospheric changes. The third measurement beam Ma may be subject to the same, or at least similar, atmospheric changes as the first and second measurement beams M_{X}, M_{Y}. The processing unit 176, 276 may therefore use the detected reflected third measurement beam as a standard (or etalon) to improve the determination of the position x,y of the objective lens 122 relative to the substrate 160, 260.

In Figure 3, the third mirror 174_{A} is arranged to deflect the third measurement beam MA, received from the third sensor head 173_{A}, toward the second mirror 174_{Y}, and to deflect the reflected third measurement beam, received from the second mirror 174_{Y} back toward the third sensor head 173_{A}. The third sensor head 173_{A}, the third mirror 174_{A}, and the second mirror 173_{Y}, are all attached at the stage 150, such that they move together with the stage 150. Thereby, the relative positions of the third sensor head 173_{A}, the third mirror 174_{A}, and the second mirror 173_{Y} does not vary during operation of the system 100.

In Figure 5, on the other hand, the third mirror 274_{A} forms part of the first mirror 274_{X}, such that the third measurement beam MA is reflected back towards the third sensor head 273_{A} by the first mirror 274_{X}. Both the third sensor head 273_{A} and the first mirror 274_{X} are attached at the stage, such that a distance between them does not vary during operation of the system 200.

With reference to Figures 7, 8, and 9, substrate pattern systems 700, 800, 900 will be described.

Figure 7 is a schematic illustration of a substrate pattern writer 700, also known as a pattern generator or a laser writer. The substrate pattern writer 700 is configured to generate or write a pattern into the substrate 760. The substrate 760 comprises a plurality of layers. A carrier layer 761 may for example comprise a quartz or a glass substrate. A pattern layer 762 may for example comprise a chrome and/or chrome oxide layer. A resist layer 763 may comprise a photoresist layer. The substrate pattern writer 700 is configured to write a pattern into the resist layer 763 using a laser beam L or an electron beam (not illustrated).

The substrate pattern writer, or pattern writer, 700 comprises a laser source 781, configured to generate a writing beam L₁. The pattern writer 700 also comprises a pattern preparation module 782, configured prepare a pattern to be transferred to, or written into, the substrate 760. The pattern preparation module delivers the prepared pattern data D₁ to a modulator 783. The modulator 783 modulates the writing beam L₁ based on the pattern data D₁, to encode the pattern data D₁ into the writing beam, and outputs a modulated writing beam L_{M}. The modulator 783 may for example modulate an intensity of the writing beam L₁ based on the pattern data D₁.

In the tool head 720, the modulated writing beam L_{M} is focused, using the objective lens 722, as the laser beam L, onto a point of interest Pᵢ of the resist layer 763. When subjected to the laser beam L, a chemical or physical property of the resist layer 763 may change. As an example, for a polymer-based photoresist layer 763, the energy provided by the laser beam L may locally cut polymer chains in the layer 763, into shorter chains, which may alter the properties of the resist layer 763. By varying the intensity of the laser beam L in accordance with the pattern, as the tool head 720 moves relative to the substrate 760, the pattern may be transferred into the resist layer 763. Specifically, different portions of the resist layer may be exposed to different intensity level, which may result in a pattern of regions of the resist later 763 having different chemical or physical properties. In Figure 7, the dark regions 765 of the resist layer 763 have been exposed to a higher intensity level of the laser beam L as the tool head 720 has moved relative to the substrate 760, while light regions 764 have been exposed to a lower intensity level of the laser beam L. For example, the laser beam L may be turned off as the tool head moves 720 across regions 764 that are not to be exposed, while the laser is turned on as the tool head moves 720 across regions 765 that are to be exposed.

After the pattern generator 700 has written or transferred the pattern into the resist layer 763, the resist layer 763 may be developed. That is, the resist layer 763 may be treated such that the pattern in the resist layer 763 may be transferred to the pattern layer 762 below the resist layer 763. For example, substrate 760 may be treated chemically or washed, such that either the exposed regions 765 or the non-exposed regions 764 of the resist layer 763 are removed. In the present example, the exposed regions 765 of the resist layer in Figure 7 have been removed during manufacture of the substrate 860.

After the development of the resist layer 763, the remaining portions of the resist layer 763 may act as a mask for the pattern. The pattern layer 762 may be etched through the mask to transfer the pattern from the resist layer 763 to the pattern layer. After etching, any remaining portions of the resist layer 763 may be removed. Finally, as is illustrated in Figure 8, a cover layer 867, such as a pellicle, may be formed on the pattern layer 862, to prevent contamination of the pattern on the substrate 860. The pattern layer 862 may form a pattern of openings or apertures in the pattern layer 862, such that the substrate 860 may be used as a photomask.

Figure 8 schematically illustrates a substrate pattern inspection system 800. The substrate pattern inspection system 800, or pattern inspection system 800 or inspection system 800, is configured to generate highly detailed images of a pattern on the substrate 860, to allow for inspection of the pattern. An inspection system 800 may be configured to compare how well the pattern 862 on the substrate 860 corresponds to the original pattern data. Furthermore, the inspection system 800 may be configured to detect contamination of the substrate 860, or errors in the pattern 862.

The inspection system 800 comprises an illumination source 884, configured to provide illumination light I. In Figure 8, the illumination light is divided into reflection light Iᵣ and transmission light It. The reflection light Iᵣ is guided to the optical head 820, where it is focused onto a first side of the substrate 860 by the objective lens 822. The transmission light It is guided to an illumination unit 886, where it is focused onto a second, opposite, side of the substrate 860.

The inspection system 800 further comprises an imaging unit 885, such as a line scan camera. The tool head 820 is configured to transmit light J, gathered by the objective lens 822 at a point of interest Pᵢ on the substrate 860, to the imaging unit 885 as the tool head 820 is moved relative to the substrate 860. In other words, the imaging unit 885 is configured to scan the substrate 860 through the objective lens 822. The carrier layer 861 and the pellicle 867 may be light-transmissive, while the pattern layer 862 may be reflective. Thus, some of the reflection light Iᵣ may be reflected by the pattern layer 862 toward the tool head 820. The reflected reflection light may be gathered by the objective lens and detected by the imaging unit 885 as a first representation of the pattern on the substrate 862. Simultaneously, or separately, the illumination unit 886 may illuminate the second surface of the substrate 860 with the transmission light It. Some of the transmission light It is reflected by the pattern layer 862, while other transmission light It is transmitted through the carrier layer 861 and the cover layer 867, toward the tool head. The transmitted transmission light may be gathered by the objective lens and detected by the imaging unit 885 as a second representation of the pattern on the substrate 862. Thus, the light J gathered by the objective lens 822 at the point of interest Pᵢ may comprise reflection light Iᵣ reflected by the pattern layer 862 and/or transmission light It transmitted by the substrate 860.

The inspection system 800 may further comprise a processor (not depicted) configured to detect errors, defects, or contaminations of the pattern or on the substrate 860 based on a scan of the substrate 860 detected or generated by the line scanning camera 885 and a position of the tool head 820 in relation to the substrate 860 during said scan.

When working in micro- or nanoscale, the precise positioning of the pattern on the substrate is a crucial quality measure. As previously mentioned, photomasks may be used to mass produce semiconductor devices. An error in the position of the pattern on the photomask may result in corresponding errors in the semiconductor devices manufactured using the photomask.

To verify the positioning of the pattern on the substrate, a substrate pattern measurement system 900 may be used. Figure 9 is a schematic illustration of substrate pattern measurement system 900, or simply a pattern measurement system 900, or a measurement system 900. The measurement system 900 comprises an illumination source, configured to provide illumination light I. The illumination light I is guided to the tool head 920 and focused onto a point of interest Pᵢ on the substrate 960. At least some of the illumination light K is reflected back toward the tool head 920 and transmitted to an imaging unit 988. The imaging unit 988 is configured to capture an image of a portion of the substrate 960 through the objective lens 922.

The measurement system 900 may further comprise a processor (not depicted) configured to detect a reference mark on the substrate 960 in the image captured by the imaging unit 988. The processor may further determine a position of the reference mark on the substrate 960 based on a position of the reference mark in the image, and a position of the toolhead relative to the substrate 960 at the time of capture of the image.

The person skilled in the art realizes that the present invention by no means is limited to the preferred embodiments described above. On the contrary, many modifications and variations are possible within the scope of the appended claims.

For example, the positioning system 170 described above with reference to Figures 3 and 4, and in relation to the first substrate pattern system 100, may be implemented in a substrate pattern system 200 as described above with reference to Figures 5 and 6. Similarly, the positioning system 270 described above with reference to Figures 5 and 6, and in relation to the second substrate pattern system 200, may be implemented in a substrate pattern system 100 as described above with reference to Figures 3 and 4.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A substrate pattern system (100) comprising:
a stage (150) configured to support a substrate (160); and
a tool head (120) comprising an objective lens (122) having a focal point at a substrate supported by the stage;
wherein the tool head and/or the stage is movable to provide relative motion between the tool head and the stage along a first axis (X) and a second axis (Y); and
wherein the substrate pattern system further comprises a positioning system (170) comprising:
a first mirror (174_{X}) arranged along a first edge of the stage and having a first mirror surface facing the stage;
a second mirror (174_{Y}) arranged along a second edge of the stage and having a second mirror surface facing the stage, wherein the second edge is adjacent to the first edge;
a laser source (171);
a first sensor head (173_{X}) attached to the tool head, the first sensor head being configured to receive a first laser beam from the laser source, emit the first laser beam as a first measurement laser beam (M_{X}) toward the first mirror, and receive a first reflected laser beam from the first mirror;
a second sensor head (173_{Y}) attached to the tool head, the second sensor head being configured to receive a second laser beam from the laser source, emit the second laser beam as a second measurement laser beam (M_{Y}) toward the second mirror, and receive a second reflected laser beam from the second mirror;
a detector (177) arranged to detect the first reflected laser beam and the second reflected laser beam; and
a processor (176) configured to determine a first position (x) along the first axis and a second position (y) along the second axis of the objective lens relative to the stage based on the first reflected laser beam and the second reflected laser beam.

2. The substrate pattern system of claim 1, wherein:
the first sensor head is optically connected to the laser source via a first optical fiber (172_{X}), and configured to receive the first laser beam via the first optical fiber; and
the second sensor head is optically connected to the laser source via a second optical fiber (172_{Y}) and configured to receive the second laser beam via the second optical fiber.

3. The substrate pattern system of claim 2, wherein:
the first sensor head is configured to generate a first reference beam by internal reflection at an end of the first optical fiber;
the second sensor head is configured to generate a second reference beam by internal reflection at an end of the second optical fiber;
the detector is further arranged to detect the first reference beam and the second reference beam; and
the processor is configured to determine the first position and the second position of the objective lens based further on the first reference beam and the second reference beam.

4. The substrate pattern system of any of claims 1-2, further comprising:
a first beam splitter (278_{X}) arranged to split the first laser beam into the first measurement beam directed toward the first mirror and a first reference beam directed toward the detector; and
a second beam splitter (278_{Y}) arranged to split the second laser beam into the second measurement beam directed toward the second mirror and a second reference beam directed toward the detector; wherein
the detector is further arranged to detect the first reference beam and the second reference beam; and
the processor is configured to determine the first position and the second position of the objective lens based further on the first reference beam and the second reference beam.

5. The substrate pattern system of any of the preceding claims, further comprising an objective lens holder (124) arranged to support the objective lens; wherein
the first sensor head is arranged to emit the first measurement beam at the objective lens holder; and
the second sensor head is arranged to emit the second measurement beam at the objective lens holder.

6. The substrate pattern system of any of the preceding claims, wherein:
the first sensor head is arranged to emit the first measurement beam along a first measurement axis which intersects an optical axis (O_{A}) of the objective lens; and
the second sensor head is arranged to emit the second measurement beam along a second measurement axis which intersects the optical axis.

7. The substrate pattern system of any of the preceding claims, wherein the laser source and the detector form part of an interferometer.

8. The substrate pattern system of any of the preceding claims, wherein the tool head is movable along a third axis (Z) perpendicular to the first and second axis.

9. The substrate pattern system of any of the preceding claims wherein the laser source comprises a laser source beam splitter arranged to split a laser beam generated by the laser source into the first laser beam and the second laser beam.

10. The substrate pattern system of any of the preceding claims, wherein the substrate pattern system is a substrate pattern writer (700), configured to write a pattern into a resist layer (763) on the substrate, and wherein the objective lens is configured to focus a writing laser beam (L) onto the resist layer.

11. The substrate pattern system of any of claims 1-9, wherein the substrate pattern system is a substrate pattern inspection (800) system comprising an imaging unit (885) configured to scan at least a portion of the substrate through the objective lens.

12. The substrate pattern system of any of claims 1-9, wherein the substrate pattern system is a substrate pattern measurement (900) system comprising an imaging unit (988) configured to capture an image of a portion the illuminated substrate through the objective lens.

13. The substrate pattern system of any of the preceding claims, wherein the substrate is substrate for a photomask or a wafer.

14. The substrate pattern system of any of the preceding claims, wherein the positioning system further comprises:
a third mirror (174_{A}); and
a third sensor head (173_{A}) arranged to receive a third laser beam from the laser source, emit the third laser beam toward the third mirror and receive a third reflected laser beam from the third mirror; wherein
the third mirror is arranged at a fixed distance from the third sensor head;
the detector is further configured to detect the third reflected laser beam; and
the processor is configured correct at least one of the determined first position and second position of the objective lens based on the reflected third laser beam.

15. The substrate pattern system of claim 14, wherein the third sensor head is optically connected to the laser source via a third optical fiber (172_{A}).
